# EUROPEAN PATENT APPLICATION

(11) **EP 1 526 642 A2**
(43) Date of publication of application: **27.04.2005**
(21) Application number: 04024568.0
(22) Date of filing: 14.10.2004
(51) Int. Cl.: H03J 1/00

(54) **Receiver**

(30) Priority: 21.10.2003 JP 2003361033
(71) Applicant: Pioneer Corporation, Meguro-ku, Tokyo (JP)
(72) Inventor: Suganuma, Hisashi c/o Kawagoe Koujou, Kawagoe-shi Saitama-ken 350-8555 (JP)
(74) Representative: Sajda, Wolf E., Dipl.-Phys.

(57) **Abstract**

An improved receiver comprises n (n is natural number not smaller than two) signal processing units (CQ1-CQn)for performing signal processing on intermediate frequency signal, a selecting circuit (SEL) , and a maximum value detecting unit (DMX). The signal processing units (CQ1-CQn) comprise first to nth IF filters (BF1-BFn) set to respective pass bandwidths (BW1-BWn) determined by dividing a normal pass bandwidth into n portions, first to nth detectors (DT1-DTn) for detecting intermediate frequency signals band-limited by the respective IF filters(BF1-BFn), and first to nth envelope detectors (EV1-Evn) for detecting the envelops of the intermediate frequency signals and outputting respective envelope signals. The maximum value detecting unit (DMX) detects an envelope signal having the maximum amplitude among the envelope signals, and outputs a control signal (SW) indicating the demodulation signal corresponding to the envelope signal detected. The selecting circuit (SEL) selectively extracts signal components of the demodulation signal designated by the control signal (SW), and synthesizes the same on a time axis.

## Description

### BACKGROUND OF THE INVENTION

The present invention relates to a receiver such as an FM receiver, and more particularly to a receiver having an improved practical sensitivity and the like.

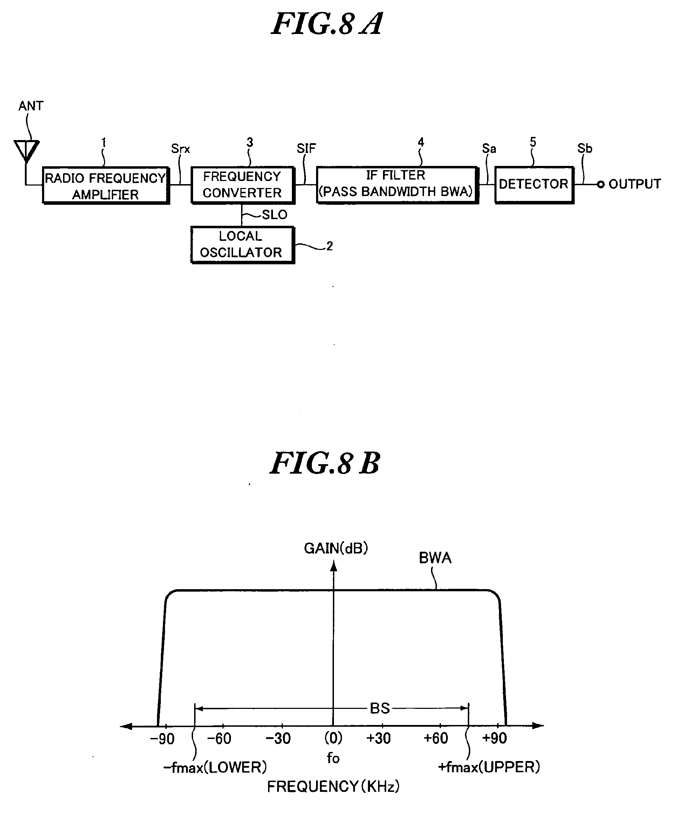

Referring to Fig. 8A, description will be given of a typical configuration of an FM receiver. A radio frequency reception signal output from a receiving antenna ANT is amplified by a radio frequency amplifier 1. A frequency converter 3 mixes the amplified reception signal Srx with a local oscillation signal SLO from a local oscillator 2 for detection, thereby frequency-converting the same into an intermediate frequency signal SIF. The intermediate frequency signal SIF is supplied to a detector (discriminator) 5 through an IF filter 4 which has a predetermined pass bandwidth BWA.

The foregoing intermediate frequency signal SIF is limited to the pass bandwidth BWA when passing through the IF filter 4. The detector 5 performs FM detection on the band- limited intermediate frequency signal Sa to output a demodulation signal Sb.

Here, as shown in Fig. 8B, the pass bandwidth BWA of the IF filter 4 is determined so as to cover a shift band BS between a lower maximum frequency shift (-fmax) and an upper maximum frequency shift (+fmax).

That is, according to the principle of FM modulation and demodulation, the frequency of an FM wave resulting from the FM modulation of a sound wave deviates from a carrier frequency fo in proportion to the amplitude of the sound wave. The maximum frequency shifts ±fmax are the deviations in frequency (the amounts of deviation from the carrier frequency fo) for situations where the sound wave reaches its maximum amplitudes. On this account, the pass bandwidth BWA of the IF filter 4 is determined so as to cover the shift band BS between the maximum frequency shifts (-fmax) and (+fmax) with the carrier frequency fo as the center frequency = 0.

For example, in the case of FM broadcasts, the maximum frequency shifts (±fmax) of the FM waves are determined as ±75 kHz. In order to cover the shift band BS between ±75 kHz, the IF filter 4 is given a pass bandwidth BWA of, e.g., 180 kHz which ranges from -90 kHz to +90 kHz.

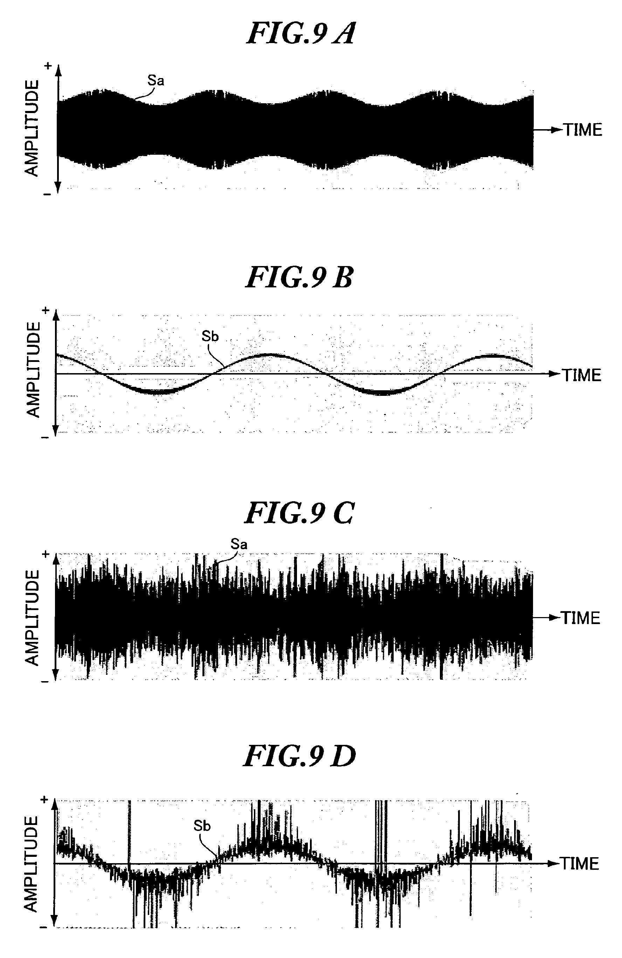

By the way, in the typical FM receiver described above, the intermediate frequency signal Sa output from the IF filter 4 and the demodulation signal Sb output from the detector 5 are desirably required to trace waveforms containing no noise component, as shown in the waveform charts of Figs. 9A and 9B. In the vicinity of the practical sensitivity, however, noise components canbe superimposed on the waveforms as shown in the waveform charts of Figs. 9C and 9D, causing harsh sound when reproduced by loudspeakers or the like.

Then, there has conventionally been proposed the technique of narrowing the pass bandwidth BWA of the IF filter 4 with the foregoing carrier frequency fo at the center so that the adverse effect of thermal noise and the like occurring from the radio frequency amplifier 1 is reduced for an improved noise figure (NF). This can reduce upper noise components of the intermediate frequency signal Sa in the vicinity of the practical sensitivity.

Nevertheless, simply narrowing the pass bandwidth BWA of the IF filter 4 with the carrier frequency fo at the center can cause such problems as distortion of the demodulation signal Sb detected by the detector 5 and crosstalk with adjacent channels, possibly hampering the improvement to the practical sensitivity.

### SUMMARY OF THE INVENTION

The present invention has been achieved in view of the foregoing conventional problems. It is thus an object of the present invention to provide a receiver which achieves an improved practical sensitivity without causing distortion of, e.g., the demodulation signal or impairing the capability of precluding interference with adjacent channels.

According to a first aspect of the present invention, a receiver comprises: a plurality of band-pass filters set to respective pass bandwidths determined by dividing a normal bandwidth covering a shift band of an intermediate frequency signal into two or more portions, the band-pass filters receiving the intermediate frequency signal and outputting intermediate frequency signals band-limited to the respective pass bandwidths; envelope detecting means for detecting envelops of the respective intermediate frequency signals band-limited and outputting envelope signals indicating the envelops of the respective intermediate frequency signals; detectors for performing detection on the intermediate frequency signals band-limited and outputting demodulation signals, respectively; maximum value detecting means for detecting an envelope signal having a maximum amplitude from among the envelope signals; and selecting means for selectively extracting signal components of the demodulation signal corresponding to the envelope signal having the maximum amplitude from among the demodulation signals output from the detectors, and generating and outputting a demodulation signal synthesized on a time axis.

According to a first aspect of the present invention, a receiver comprises: a plurality of band-pass filters set to respective pass bandwidths determined by dividing a normal bandwidth covering a shift band of an intermediate frequency signal into two or more portions, the band-pass filters outputting intermediate frequency signals band-limited to the respective pass bandwidths based on the intermediate frequency signal; envelope detecting means for detecting envelops of the respective intermediate frequency signals band-limited and outputting envelope signals indicating the envelops of the respective intermediate frequency signals; maximum value detecting means for detecting an envelope signal having a maximum amplitude from among the envelope signals; selecting means for selectively extracting signal components of the intermediate frequency signal corresponding to the envelope signal having the maximum amplitude from among the intermediate frequency signals output from the plurality of band-pass filters, and for generating and outputting an intermediate frequency signal synthesized on a time axis; and a detector for performing detection on the intermediate frequency signal output from the selecting means to output a demodulation signal.

### BRIEF DESCRIPTION OF THE DRAWINGS

These and other obj ects and advantages of the present invention will become clear from the following description with reference to the accompanying drawings, wherein:
Fig. 1 is a block diagram showing the conf iguration of a receiver according to a best mode for carrying out the invention;
Fig. 2 is a diagram showing the pass bands of IF f ilters provided in the receiver shown in Fig. 1;
Fig. 3 is a block diagram showing the configuration of the receiver according to an embodiment;
Fig. 4 is a diagram showing the pass bands of IF f ilters provided in the receiver shown in Fig. 3;
Figs. 5A to 5D are charts showing the waveforms of intermediate frequency signals output from the respective IF filters 9, BF1, BF2, and BF3 provided in the receiver shown in Fig. 3;
Figs. 6A to 6F are charts showing the waveforms of envelope signals and control signals output from envelope detectors EV1, EV2, EV3 and comparators DMX1, DMX2 provided in the receiver shown in Fig. 3;
Figs. 7A to 7E are charts showing the waveforms of demodulation signals output from detectors and selecting circuits provided in the receiver shown in Fig. 3;
Figs. 8A and 8B are diagrams for explaining the configuration of a conventional FM receiver and the pass band its IF filter is set to; and
Figs. 9A to 9D are charts for explaining the conventional technology.

### DETAILED DESCRIPTION OF THE PREFERRED EMBODIMENTS

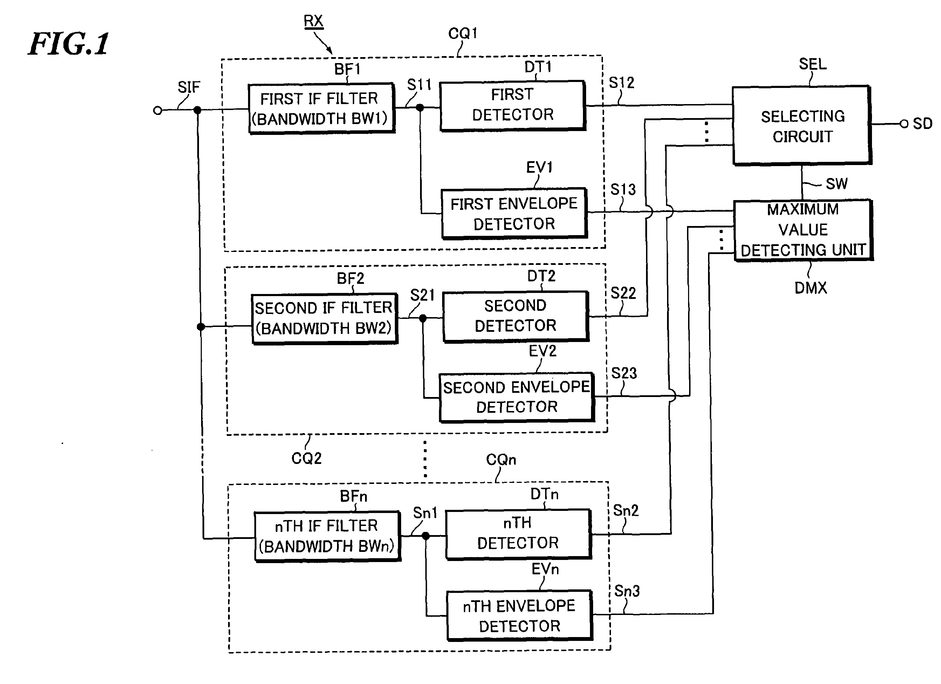

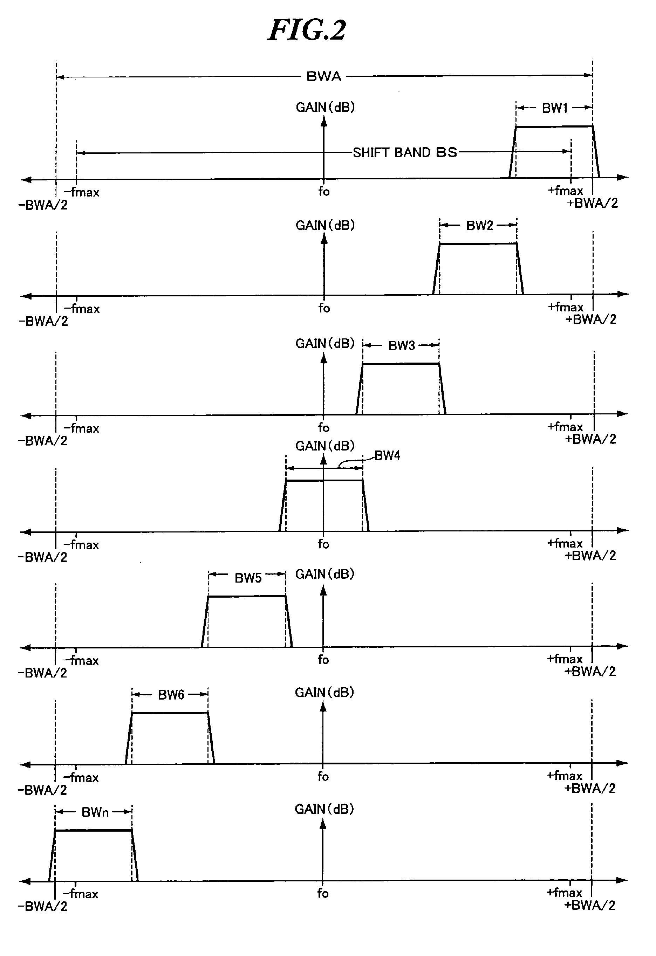

Hereinafter, a best mode for carrying out the invention will be described with reference to Figs. 1 and 2. Fig. 1 is a block diagram showing the configuration of a receiver according to the present embodiment. Fig. 2 is a diagram showing the pass bandwidths of a plurality of IF filters provided in the receiver.

In Fig. 1, the receiver RX of the present embodiment comprises n (n is a natural number no smaller than two) signal processing units CQ1 to CQn for performing signal processing on an intermediate frequency signal SIF output from a frequency converter (not shown) , along with a selecting circuit SEL and a maximum value detecting unit DMX.

The signal processing unit CQ1 is provided with a first IF filter BF1, a first detector DT1, and a first envelope detector EV1. The signal processing unit CQ2 is provided with a second IF filter BF2, a second detector DT2, and a second envelope detector EV2. The same holds subsequently, and the signal processing unit CQn is provided with an nth IF filter BFn, an nth detector DTn, and an nth envelope detector EVn.

The first to nth IF filters BF1 to BFn are band-pass filters set to predetermined pass bandwidths BW1 to BWn, respectively. The first IF filter BF1 limits the intermediate frequency signal SIF to the pass bandwidth BW1 for output. The second IF filter BF2 limits the intermediate frequency signal SIF to the pass bandwidth BW2 for output. The same holds subsequently, and the nth IF filter BFn limits the intermediate frequency signal SIF to the pass bandwidth BWn for output.

More specifically, as shown in Fig. 2, the pass bandwidths BW1 to BWn of the respective first to nth IF filters BF1 to BFn are set to respective frequency ranges where a bandwidth (hereinafter, referred to as "normal bandwidth") BWA which covers the shift band BS between a lower maximum frequency shift (-fmax) and an upper maximum frequency shift (+fmax) with the carrier frequency fo at the center is divided into n portions. The pass bandwidths BW1 to BWn are also determined not to overlap each other, so that the pass bandwidths BW1 to BWn sum up to the normal bandwidth BWA.

The intermediate frequency signal SIF to be input to the first to nth IF filters BF1 to BFn is not flattened in amplitude by a limiter or the like. In other words, the intermediate frequency signal SIF varies in amplitude in proportion to the intensity of the reception signal received by the antenna. The maximum frequency shifts (-fmax), (+fmax), the shift band BS, and the normal bandwidth BWA mentioned above are thus determined based on the maximum amplitude of such an intermediate frequency signal SIF.

Then, as shown in Fig. 2, within the normal bandwidth BWAbetween a frequency (-BWA/2) and a frequency (+BWA/2) with the foregoing carrier frequency fo at the center, the pass bandwidth BW1 of the first IF filter BF1 is determined to range from a lower cutoff frequency (+BWA/2-BW1) to an upper cutoff frequency (+BWA/2). The pass bandwidth BW2 of the second IF filter BF2 is determined to range from a lower cutoff frequency (+BWA/2-BW1-BW2) to an upper cutoff frequency (+BWA/2-BW1). The same holds subsequently, and the pass bandwidth BWn of the nth IF filter BFn is determined to range from a lower cutoff frequency (-BWA/2) to an upper cutoff frequency (-BWA/2+BWn).

Note that the pass bandwidths BW1 to BWn need not be an identical bandwidth (BWA / n) which is determined by dividing the normal bandwidth BWA into n equal portions. As long as the pass bandwidths BW1 to BWn can be determined to sum up to the normal bandwidth BWA, at least one of the pass bandwidths is allowed to differ from the others. Further, all the pass bandwidths BW1 to BWn may differ from one another.

Returning to Fig. 1, the first detector DT1 performs FM detection on an intermediate frequency signal S11 which has been band-limited by the first IF filter BF1, and outputs a detected demodulation signal S12 to the selecting circuit SEL. The second detector DT2 performs FM detection on an intermediate frequency signal S21 which has been band-limited by the second IF filter BF2, and outputs a detected demodulation signal S22 to the selecting circuit SEL. The same holds subsequently, and the nth detector DTn performs FM detection on an intermediate frequency signal Sn1 which has been band-limited by the nth IF filter BFn, and outputs a detected demodulation signal Sn2 to the selecting circuit SEL.

The first envelope detector EV1 detects the envelope of the absolute value of the intermediate frequency signal S11 which is output from the first IF filter BF1, and outputs an envelope signal S13 indicating the detected envelope to the maximum value detecting unit DMX. The second envelope detector EV2 detects the envelope of the absolute value of the intermediate frequency signal S21 which is output from the second IF filter BF2, and outputs an envelope signal S23 indicating the detected envelope to the maximum value detecting unit DMX. The same holds subsequently, and the nth envelope detector EVn detects the envelope of the absolute value of the intermediate frequency signal Sn1 which is output from the nth IF filter BFn, and outputs an envelope signal Sn3 indicating the detected envelope to the maximum value detecting unit DMX.

The maximum value detecting unit DMX receives the envelope signals S13, S23, ... Sn3 in parallel, detects the amplitudes of the respective signals one by one, and determines which of the envelope detectors EV1 to EVn is outputting the envelope signal of the maximum amplitude at the current moment. In addition, the maximum value detecting unit DMX supplies the selecting circuit SEL with a control signal SW which designates the signal processing unit provided with the determined envelope detector.

For example, if the envelope signal S13 has the maximum amplitude among the envelope signals S13, S23, ... Sn3, then the maximum value detecting unit DMX outputs the control signal SW which designates the signal processing unit CQ1.

The selecting circuit SEL is composed of an n-input one-output analog multiplexer or the like. It inputs the demodulation signals S12, S22, ... Sn2 from the first to nth detectors DT1 to DTn in parallel, and selectively outputs the demodulation signal which has been output from the detector in the signal processing unit designated by the foregoing control signal SW.

For example, when the control signal SW designating the signal processing unit CQ1 is supplied, the selecting circuit SEL outputs the demodulation signal S12 output from the first detector DT1 as the selected demodulation signal SD.

With the receiver RX having such a configuration, the first to nth envelope detectors EV1, EV2, ... EVn can detect the envelops of the respective intermediate frequency signals S11 to Sn1 which have been band-limited to the pass bandwidths BW1, BW2, ... BWn of the first to nth IF filters BF1, BF2, ... BFn. This makes it possible to generate the envelope signals S13, S23, ... Sn3 which make amplitude variations close to those of the original intermediate frequency signal while excluding noise components occurring in the vicinity of the practical sensitivity.

Then, the maximum value detecting unit DMX detects one having the maximum amplitude among these envelope signals S13, S23, ... Sn3. Moreover, the selecting circuit SEL extracts the signal components of the demodulation signal corresponding to the foregoing detected envelope signal selectively from among the demodulation signals S12, S22, ... Sn2. It is therefore possible to select the signal components containing minimum noise components out of the demodulation signals S12, S22, ... Sn2.

When the selecting circuit SEL outputs the signal components containing minimum noise components, these signal components extracted are synthesized on a time axis. Consequently, it is possible to generate a demodulation signal SD of reduced noise and distortion in the vicinity of the practical sensitivity, as well as improve the practical sensitivity without impairing the capability of precluding interference with adjacent channels.

### [Embodiment]

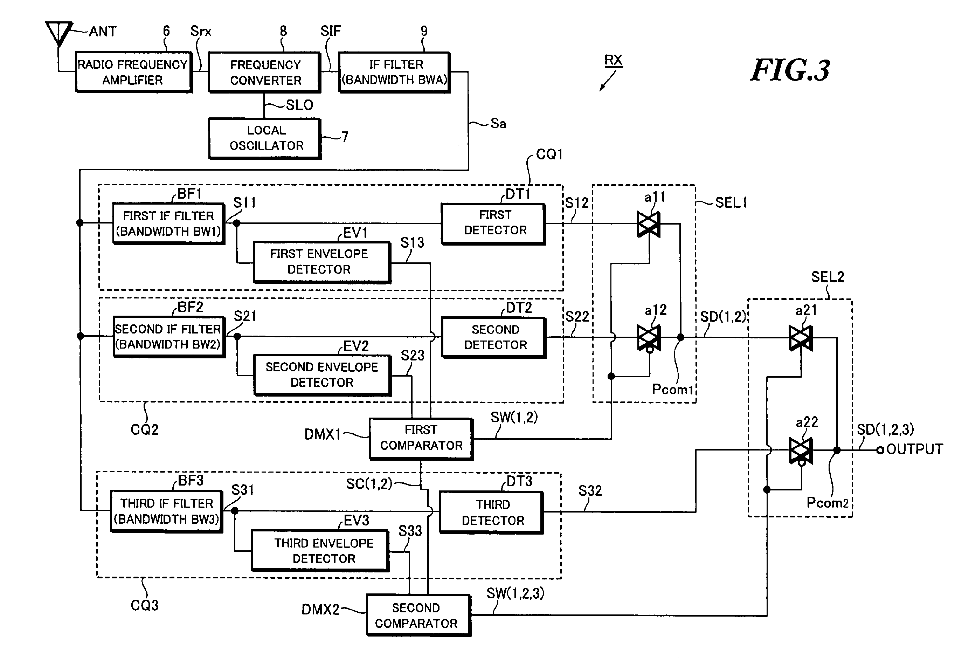

Next, with reference to Figs. 3 through 7E, description will be given of a more concrete example of the present embodiment.

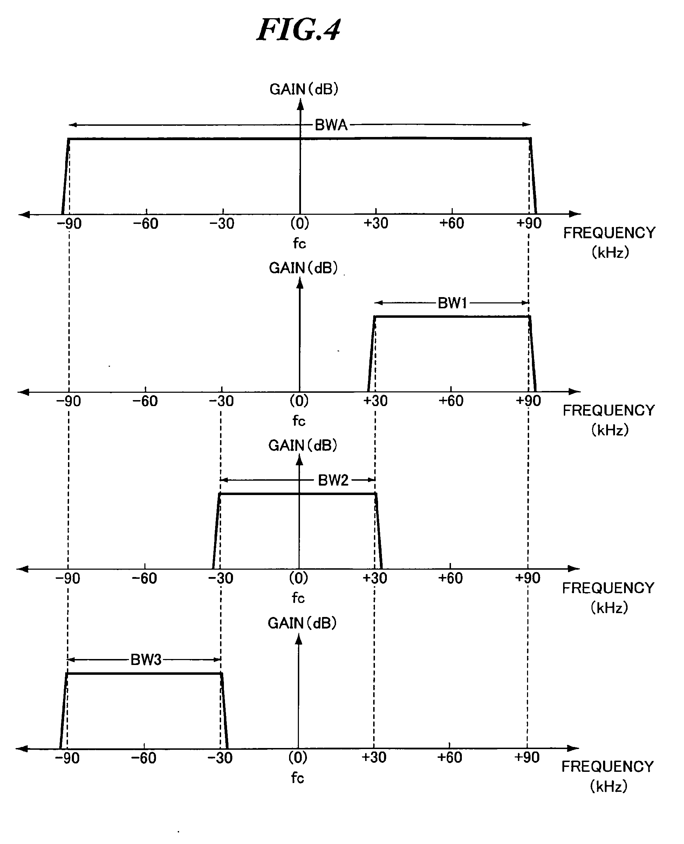

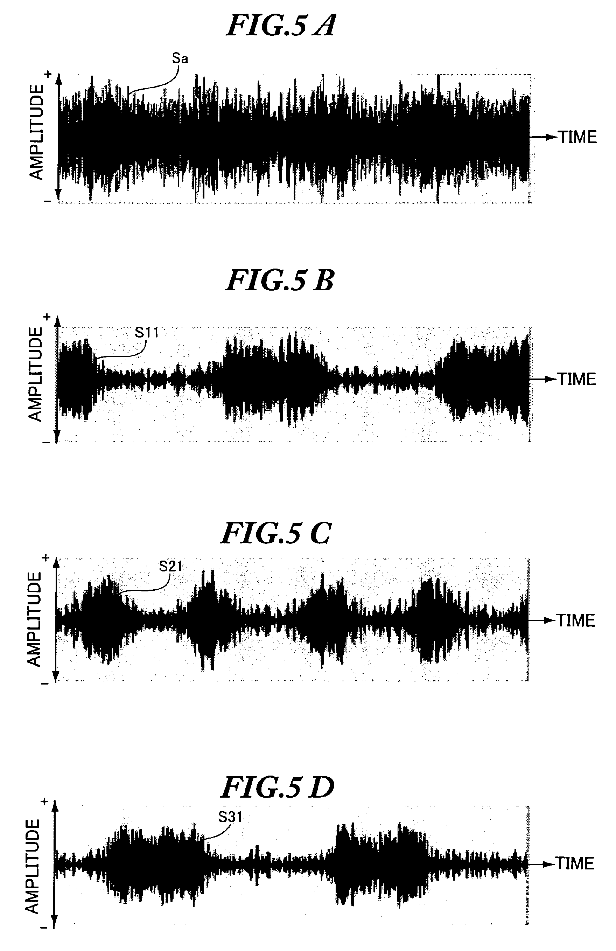

Fig. 3 is a block diagram showing the configuration of the receiver according to the present embodiment. Fig. 4 is a diagram showing the pass bands of a plurality of IF filters provided in the receiver. Figs. 5A through 7E are charts showing the waveforms of signals occurring in the receiver. Incidentally, in Figs. 3 and 4, the parts identical or equivalent to those of Figs. 1 and 2 are designated by the same reference numerals or symbols. The waveforms of Figs. 5A to 7E are each rendered to the ordinate (amplitude) and abscissa (time) of the same scales as in Figs. 9A to 9D.

In Fig. 3, the receiver RX of the present embodiment is configured to receive FM broadcasts. The receiver RX comprises a radio frequency amplifier 6, a local oscillator 7, a frequency converter 8, and an IF filter 9. The radio frequency amplifier 6 amplifies a radio frequency reception signal output from a receiving antenna ANT. The frequency converter 8 mixes the reception signal Srx amplified by the radio frequency amplifier 6 with a local oscillation signal SLO from the local oscillator 7 for detection, thereby frequency-converting the same into an intermediate frequency signal SIF. The IF filter 9 is set at a predetermined pass bandwidth BWA, and band-limits the intermediate frequency signal SIF for output.

Then, the intermediate frequency signal Sa band-limited by the IF filter 9 without being flattened in amplitude by a limiter or the like is supplied to first, second, and third IF filters BF1, BF2, and BF3 which are arranged in three signal processing circuits CQ1, CQ2, and CQ3.

Here, the maximum frequency shifts (±fmax) of the FM wave in an FM broadcast are determined as ±75 kHz with the carrier frequency fo at the center. As shown in Fig. 4, the pass bandwidth (hereinafter, referred to as "normal bandwidth") BWA of the IF filter 9 is thus determined as 180 kHz, or from -90 kHz to +90 kHz with the carrier frequency fo at the center, so as to cover the shift band BS between the maximum frequency shifts (±75 kHz).

The pass bandwidths BW1, BW2, and BW3 of the first, second, and third IF filters BF1, BF2, and BF3 are each determined to have a frequency range of 60 kHz which is obtained by dividing the foregoing normal bandwidth BWA ranging from -90 kHz to +90 kHz into three equal parts.

More specifically, the pass bandwidth BW1 of the first IF filter BF1 is determined to have a frequency range of +30 kHz to +90 kHz with the carrier frequency fo as the center frequency = 0. The pass bandwidth BW2 of the second IF filter BF2 is determined to have a frequency range of -30 kHz to +30 kHz, again with the carrier frequency fo as the center frequency=0. The pass bandwidth BW3 of the third IF filter BF3 is determined to have a frequency range of -90 kHz to -30 kHz, again with the carrier frequency fo as the center frequency = 0. Consequently, the sum of the pass bandwidths BW1, BW2, and BW3 coincides with the normal bandwidth BWA.

Apart from the first, second, and third IF filters BF1, BF2, and BF3, the signal processing units CQ1, CQ2, and CQ3 also have first, second, and third detectors DT1, DT2, and DT3, and first, second, and third envelope detectors EV1, EV2, and EV3 as in the embodiment shown in Fig. 1.

The first, second, and third detectors DT1, DT2, andDT3 perform FM detection on intermediate frequency signals S11, S21, and S31 which have been band-limited by the first, second, and third IF filters BF1, BF2, and BF3, thereby outputting detected demodulation signal S12, S22, and S32, respectively.

The first, second, and third envelope detectors EV1, EV2, and EV3 detect the envelops of the absolute values of the intermediate frequency signals S11, S21, and S31, thereby outputting envelope signals S13, S23, and S33, respectively.

Then, in the case of the receiver RX according to the present embodiment, the maximum value detecting unit DMX shown in Fig. 1 is composed of first and second comparators DMX1 and DMX2 shown in Fig. 3.

The first comparator DMX1 comprises a comparator, and an analog switch or the like. The comparator detects the amplitudes of the envelope signals S13 and S23 one by one, and compares the same. According to the result of comparison by the comparator, the analog switch or the like transfers either one of the envelope signals S13 and S23 which has a greater amplitude as an envelope signal SC(1,2) to be supplied to the second comparator DMX2.

The foregoing comparator then outputs a control signal SW (1, 2) of logic "0" to a selecting circuit SEL1 to be described later if the amplitude of the envelope signal S13 is greater than that of the envelope signal S23 at the current moment (i.e., S13 > S23). It outputs the control signal SW(1,2) of logic "1" if the amplitude of the envelope signal S13 is smaller than or equal to that of the envelope signal S23 (i.e., S13 ≤ S23).

The foregoing analog switch or the like provided in the first comparator DMX1 selects the envelope signal S13 while the result of comparison by the comparator, or the control signal SW(1,2), shows logic "0," and selects the envelope signal S23 while the control signal SW(1,2) shows logic "1." The selected one is output as the envelope signal SC(1,2) to be supplied to the second comparator DMX2.

The second comparator DMX2 comprises a comparator for detecting the amplitude of the envelope signal SC (1, 2) supplied from the first comparator DMX1 and the amplitude of the envelope signal S33 output from the third IF filter BF3 one by one, and comparing the same.

Then, the comparator of the second comparator DMX2 outputs a control signal SW(1,2,3) of logic "0" to a selecting circuit SEL2 to be described later if the amplitude of the envelope signal SC (1, 2) is greater than that of the envelope signal S33 at the current moment (i.e., SC(1,2) > S33). It outputs the control signal SW(1,2,3) of logic "1" if the amplitude of the envelope signal SC(1,2) is smaller than or equal to that of the envelope signal S33 (i.e., SC(1,2) ≤ S33).

Moreover, in the receiver RX of the present embodiment, the selecting circuit SEL shown in Fig. 1 is composed of the first and second selecting circuits SEL1 and SEL2 shown in Fig. 3.

The first selecting circuit SEL 1 comprises analog switches a11 and a12 which complementarily turn on and off according to the control signal SW(1,2). The demodulation signal S12 from the first detector DT1 and the demodulation signal S22 from the second detector DT2 are supplied to the input end of the analog switch a11 and the input end of the analog switch a12, respectively. The output ends Pcom1 of the analog switches a11 and a12 are connected in common.

While the control signal SW(1,2) shows logic "0," the analog switch a11 turns on (conducting state) and the analog switch a12 turns off (interrupted state), whereby the demodulation signal S12 is transferred to the foregoing output ends Pcom1 in common connection. On the other hand, while the control signal SW(1,2) shows logic "1," the analog switch a11 turns off (interrupted state) and the analog switch a12 turns on (conducting state), whereby the demodulation signal S22 is transferred to the foregoing output ends Pcom1 in common connection.

Incidentally,for ease ofdescription,the demodulationsignal S12 or S22 occurring on the foregoing output ends Pcom1 will hereinafter be referred to as a demodulation signal SD(1,2).

The second selecting circuit SEL2 has analog switches a21 and a22 which complementarily turn on and off according to the control signal SW(1,2,3). The demodulation signal SD(1,2) from the first selecting circuit SEL1 and the demodulation signal S32 from the third detector DT3 are supplied to the input end of the analog switch a21 and the input end of the analog switch a22, respectively. The output ends Pcom2 of the analog switches a21 and a22 are connected in common. The output ends Pcom2 are further connected to a circuit of the subsequent stage for driving not-shown loudspeakers, through a predetermined output terminal or the like.

While the control signal SW(1, 2, 3) shows logic "0," the analog switch a21 turns on (conducting state) and the analog switch a22 turns off (interrupted state), whereby the demodulation signal SD(1, 2) is transferred to the foregoing output ends Pcom2 in common connection. While the control signal SW(1,2,3) shows logic "1," the analog switch a21 turns off (interrupted state) and the analog switch a22 turns on (conducting state), whereby the demodulation signal S32 is transferred to the foregoing output ends Pcom2 in common connection.

In this way, the receiver RX of the present embodiment detects the envelope signal having the maximum amplitude from among the envelope signals S13, S23, and S33 output from the first to third envelope detectors EV1 to EV3 by using the first and second comparators DMX1 and DMX2. The maximum value detecting unit DMX shown in Fig. 1 is thus realized.

Moreover, the selecting circuits SEL1 and SEL2 select the signal components of the demodulation signals S12, S22, and S32 output from the first to third detectors DT1 to DT3 according to the control signals SW(1,2) and SW(1,2,3) from the first and second comparators DMX1 and DMX2, and finally synthesize the signal components on the common output ends Pcom2 into the demodulation signal SD(1,2,3). The selecting circuit SEL shown in Fig. 1 is thus realized.

Next, description will be given of the operation of the receiver RX having the foregoing configuration.

Suppose that an intermediate frequency signal SIF in the vicinity of the practical sensitivity, not flattened in amplitude by a limiter or the like, is output from the frequency converter 8 and passed through the IF filter 9 to generate an intermediate frequency signal Sa as shown in Fig. 5A. The intermediate frequency signal Sa is input to the first, second, and third IF filters BF1, BF2, and BF3 in parallel.

In the first IF filter BF1, the intermediate frequency signal Sa is band-limited to the foregoing pass bandwidth BW1 to output an intermediate frequency signal S11 as shown in Fig. 5B. In the second IF filter BF2, the intermediate frequency signal Sa is band-limited to the foregoing pass bandwidth BW2 to output an intermediate frequency signal S21 as shown in Fig. 5C. In the third IF filter BF3, the intermediate frequency signal Sa is band-limited to the foregoing pass bandwidth BW3 to output an intermediate frequency signal S31 as shown in Fig. 5D.

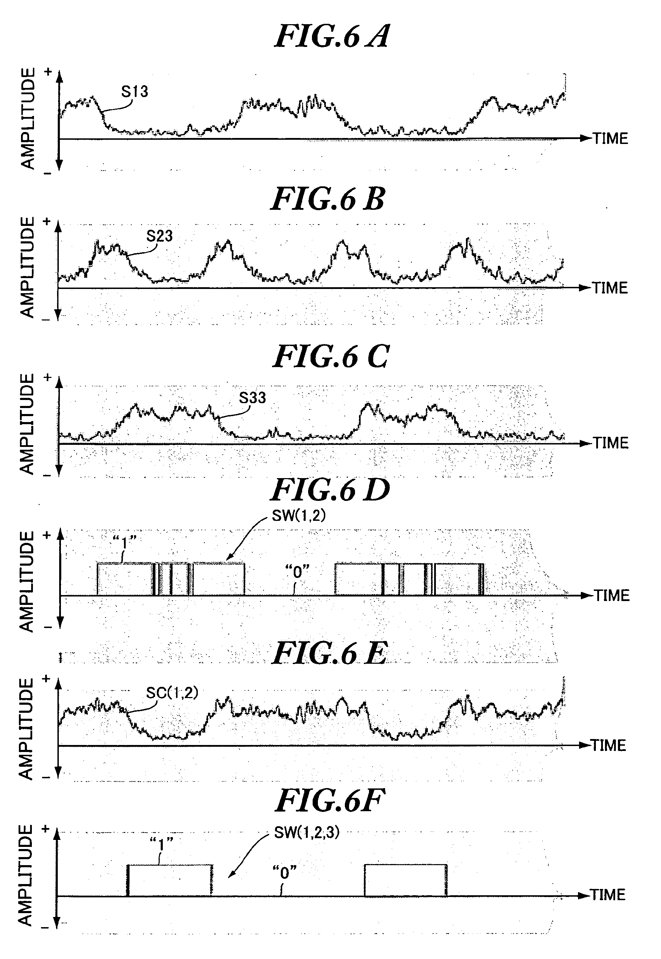

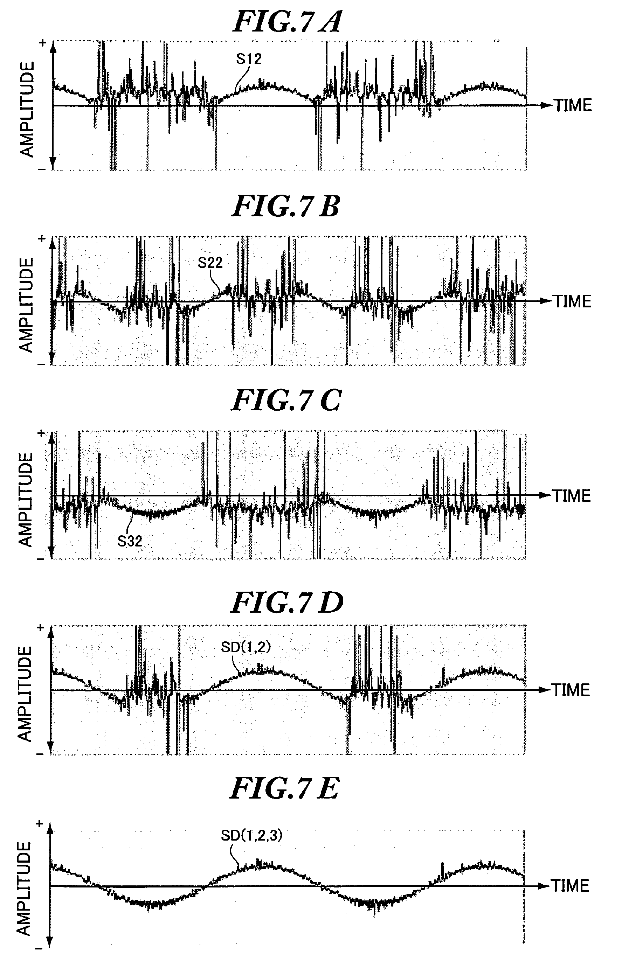

The intermediate frequency signal S11 is converted into an envelope signal S13 as shown in Fig. 6A through the foregoing envelope detection by the first envelope detector EV1. The intermediate frequency signal S11 is also converted into a demodulation signal S12 as shown in Fig. 7A through the FM detection by the first detector DT1.

The intermediate frequency signal S21 is converted into an envelope signal S23 as shown in Fig. 6B through the foregoing envelope detection by the second envelope detector EV2. The intermediate frequency signal S21 is also converted into a demodulation signal S22 as shown in Fig. 7B through the FM detection by the second detector DT2.

The intermediate frequency signal S31 is converted into an envelope signal S33 as shown in Fig. 6C through the foregoing envelope detection by the third envelope detector EV3. The intermediate frequency signal S31 is also converted into a demodulation signal S32 as shown in Fig. 7C through the FM detection by the third detector DT3.

The first comparator DMX1 compares the amplitudes of the envelope signals S13 and S23 shown in Figs. 6A and 6B. As shown in Fig. 6D, if the envelope signal S13 is greater than the envelope signal S23 in amplitude, the first comparator DMX1 outputs the control signal SW(1,2) of logic "0" to the selecting circuit SEL1. If the envelope signal S13 is smaller than or equal to the envelope signal S23 in amplitude, the first comparator DMX1 outputs the control signal SW(1,2) of logic "1." Moreover, the first comparator DMX1 selects the envelope signal S13 and the envelope signal S23 for output when the control signal SW(1,2) shows logic "0" and when the control signal SW (1,2) shows logic "1," respectively. As a result, an envelope signal SC(1,2) as shown in Fig. 6E is supplied to the second comparator DMX2.

Now, the second comparator DMX2 compares the amplitudes of the envelope signals S33 and SC(1,2) shown in Figs. 6C and 6E. As shown in Fig. 6F, if the envelope signal SC(1,2) is greater than the envelope signal S33 in amplitude, the second comparator DMX2 outputs the control signal SW(1,2,3) of logic "0" to the second selecting circuit SEL2. If the envelope signal SC(1,2) is smaller than or equal to the envelope signal S33 in amplitude, the second comparator DMX2 outputs the control signal SW(1,2,3) of logic "1."

While the control signal SW(1,2) shows logic "0," the first selecting circuit SEL1 transfers the demodulation signal S12 shown in Fig. 7A to the output ends Pcom1 through the analog switch a11. While the control signal SW(1,2) shows logic "1," the first selecting circuit SEL1 transfers the demodulation signal S22 shown in Fig. 7B through the analog switch a12. Consequently, the demodulation signal SD (1, 2) having such a waveform as shown in Fig. 7D is supplied to the second selecting circuit SEL2. Moreover, while the control signal SW(1,2,3) shows logic "0," the second selecting circuit SEL2 transfers the demodulation signal SD(1,2) shown in Fig. 7D to the output ends Pcom2 through the analog switch a21. While the control signal SW(1,2,3) shows logic "1," the second selecting circuit SEL2 transfers the demodulation signal S32 shown in Fig. 7C through the analog switch a22. Consequently, the demodulation signal SD (1,2,3) containing reduced noise components as shown in Fig. 7E is output to the circuit of the subsequent stage.

As above, according to the receiver RX of the present embodiment, the intermediate frequency signal Sa is band-limited to generate the intermediate frequency signals S11, S21, and S31 as shown in Figs. 5B to 5D. Envelope detection and FM detection are performed on these intermediate frequency signals S11, S21, and S31 to generate the envelope signals S13, S23, and S33, and the demodulation signals S12, S22, and S32. In the mean time, signal components of the demodulation signals S12, S22, and S32 are selectively extracted and synthesized on a time axis corresponding to the envelope signal having the maximum amplitude from among the envelope signals S13, S23, and S33, thereby generating the demodulation signal SD(1,2,3). It is therefore possible to generate the demodulation signal SD(1,2,3) with significant reductions of noise components and distortion as shown in Fig. 7E, and to improve the practical sensitivity without impairing the capability of precluding interference with adjacent channels.

In other words, from the comparison between the waveforms of the intermediate frequency signal Sa and the demodulation signal SD(1,2,3) shown in Fig. 5A and 7E and the waveforms of the intermediate frequency signal Sa and the demodulation signal Sb according to the conventional technology, shown in Figs. 9A to 9D, the following can be seen clearly. That is, given that the intermediate frequency signal Sa in the vicinity of the practical sensitivity of the FM detection by the receiver RX of the present embodiment (see Fig. 5A) and the intermediate frequency signal Sa in the vicinity of the practical sensitivity of the FM detection by the conventional receiver (see Fig. 9A) both contain noise components, the receiver RX of the present embodiment can generate the intermediate frequency signal SD(1,2,3) with reduced noise components and distortion as shown in Fig. 7E, whereas the conventional receiver only generates the intermediate frequency signal Sb with higher noise components and the like as shown in Fig. 9D. This confirms, even in intuitive terms, the advantage of the receiver RX of the present embodiment over the conventional receiver.

Incidentally, as shown in Fig. 3, the receiver RX of the present embodiment is configured to generate the demodulation signal SD(1,2,3) from the intermediate frequency signal Sa which is band-limited by the IF filter 9 having the normal bandwidth BWA. Nevertheless, the receiver RX may be configured so that the IF filter 9 is omitted and the intermediate frequency signal SIF output from the frequency converter 8 is input to the first, second, and third IF filters BF1, BF2, and BF3.

In the receiver RX of the present embodiment, as shown in Fig. 4, all the pass bandwidths BW1, BW2, and BW3 of the first, second, and third IF filters BF1, BF2, and BF3 are given an identical frequency range of 60 kHz. Nevertheless, the pass bandwidths BW1, BW2, and BW2 may have mutually different frequency ranges. That is, sensitivities in the vicinity of the practical sensitivity can also be improved if the first, second, and third IF filters BF1, BF2, and BF3 are only designed so that their pass bandwidths BF1, BF2, and BF3 sum up to the normal bandwidth BWA.

For example, with the normal bandwidth BWA shown in Fig. 4, the pass bandwidth BF1 can be set at 50 kHz to 90 kHz, the pass bandwidth BF2 -50 kHz to +50 kHz, and the pass bandwidth BF3 -90 kHz to -50 kHz for improved sensitivities in the vicinity of the practical sensitivity.

The receiver RX of the present embodiment comprises the three signal processing units CQ1 to CQ3, along with the two comparators DMX1, DMX2 and the two selecting circuits SEL1, SEL2. Nevertheless, it may comprise four or more signal processing units, and as many comparators and selecting circuits as corresponding to the four or more signal processing units.

The selecting circuits SEL1 and SEL2 may also be made of switching elements other than the analog switches a11 to a22 shown in Fig. 3.

As shown in Fig. 3, the receiver RX of the present embodiment is configured so that the demodulation signals S12, S22, and S32 resulting from the FM detection by the first, second, and third detectors DT1, DT2, and DT3 provided in the respective signal processing units CQ1, CQ2, and CQ3 are selectively extracted and synthesized on a time axis to generate the demodulation signal SD(1,2,3). These detectors DT1, DT2, and DT3 maybe omitted, however. In this case, the intermediate frequency signals S11, S21, and S31 are supplied directly to the analog switches all, a12, and a22 in the first and second selecting circuits SEL1 and SEL2. The output ends Pcom2 of the second selecting circuit SEL2 are then provided with a single detector, and this detector finally performs FM detection on the intermediate frequency signal occurring on the output ends Pcom2.

## Claims

1. A receiver (RX) comprising:
a plurality of band-pass filters (BF1, BF2, ... BFn) set to respective pass bandwidths determined by dividing a normal bandwidth covering a shift band of an intermediate frequency signal into two or more portions, said band-pass filters (BF1, BF2, ... BFn) receiving the intermediate frequency signal and outputting intermediate frequency signals band-limited to the respective pass bandwidths;
envelope detecting means (EV1, EV2, ... EVn) for detecting envelops of the respective intermediate frequency signals band- limited and outputting envelope signals indicating the envelops of the respective intermediate frequency signals;
detectors (DT1,DT2,... DTn)for performing detection on the intermediate frequency signals band-limited and outputting demodulation signals, respectively;
maximum value detecting means (DMX) for detecting an envelope signal having a maximum amplitude from among the envelope signals; and
selecting means (SEL) for selectively extracting signal components of the demodulation signal corresponding to the envelope signal having the maximum amplitude from among the demodulation signals output from the detectors (DT1,DT2,... DTn), and generating and outputting a demodulation signal synthesized on a time axis.

2. A receiver (RX) comprising:
a plurality of band-pass filters (BF1,BF2,BF3) set to respective pass bandwidths determined by dividing a normal bandwidth covering a shift band of an intermediate frequency signal into two or more portions, said band-pass filters (BF1,BF2,BF3) outputting intermediate frequency signals band-limited to the respective pass bandwidths based on the intermediate frequency signal;
envelope detecting means (EV1,EV2,EV3) for detecting envelops of the respective intermediate frequency signals band-limited and outputting envelope signals indicating the envelops of the respective intermediate frequency signals;
maximum value detecting means (DMX1,DMX2) for detecting an envelope signal having a maximum amplitude from among the envelope signals;
selecting means (SEL1, SEL2) for selectively extracting signal components of the intermediate frequency signal corresponding to the envelope signal having the maximum amplitude from among the intermediate frequency signals output from the plurality of band-pass filters (BF1,BF2,BF3), and for generating and outputting an intermediate frequency signal synthesized on a time axis; and
a detector for performing detection on the intermediate frequency signal output from the selecting means(SEL1,SEL2) to output a demodulation signal.

3. The receiver according to claim 1 or 2, wherein the intermediate frequency signal input to the plurality of band-pass filters (BF1,BF2,... BFn) is an unflattened intermediate frequency signal.

4. The receiver according to any one of claim 1 or 2, wherein at least one of the plurality of band-pass filters (BF1,BF2, ... BFn) is set to a bandwidth different from those of the others.
